# EUROPEAN PATENT APPLICATION

(11) **EP 2 874 194 A2**
(43) Date of publication of application: **20.05.2015**
(21) Application number: 14193547.8
(22) Date of filing: 17.11.2014
(51) Int. Cl.: H01L 51/52

(54) **Oled display and method for adjusting a spectrum of blue light of the same**

(30) Priority: 18.11.2013 CN 201310576538
(71) Applicant: EverDisplay Optronics (Shanghai) Limited, Shanghai 201508 (CN)
(72) Inventor: He, Zhi Jiang, 201508 Shanghai (CN); Ma, Shao Dong, 201508 Shanghai (CN); Huang, Chu Wan, 201508 Shanghai (CN)
(74) Representative: Szabo, Zsolt

(57) **Abstract**

A method for adjusting a spectrum of blue light emitted from an OLED display. The method includes the steps of providing a substrate (10), an anode (12), an OLED layer (13) and a cathode (11) on the substrate so that a resonant cavity is formed between the anode and the cathode, the resonant cavity has a cavity length; and adjusting the cavity length of the resonant cavity such that a portion of the spectrum components with wavelengths smaller than 435 nanometers has a energy under 50% of the spectrum.

## Description

### BACKGROUND OF INVENTION

### 1. FIELD OF INVENTION

The present invention relates to an OLED display and, more particularly, to a method for adjusting a spectrum of blue light of an OLED display.

### 2. RELATED PRIOR ART

Arguments about whether the use of electronic products for long hours would jeopardize human health are intensifying as more and more electric products are used in our everyday life. Such arguments are haunting flat-panel displays as well. Most of the arguments about flat-panel displays are focused on radiation.

Techniques for making LCDs and OLEDs are mature, and LCDs and OLED displays are replacing CRT displays. In comparison with CRT displays, LCDs and OLED displays emit only a little radiation. There are however unsolved problems of human eyes getting hurt by radiation from LCDs and OLED displays.

Visible light is a sort of electromagnetic waves, and electromagnetic waves are electromagnetic radiation. Hence, visible light is a sort of electromagnetic radiation in a broad sense, only not considered to be very harmful for humans. Visible light means electromagnetic radiation with wavelengths in the range of 390 to 760 nanometers that is visible to bare human eyes. Scientific studies have revealed that retinal cells contain a rare sort of retinene, A2E. A2E exhibits two peaks of absorption, one at 335 nanometers in the ultraviolet light zone, the other at 435 nanometers in the blue light zone. A2E is mildly toxic for retinal pigment epithelium in a dark environment. The toxicity of A2E rises tremendously in irradiation. The most common LCD and OLED emit light that includes a lot of high-energy short-wave blue light. To our best understanding, such high-energy short-wave blue light includes wavelengths in the range of 435 to 440 nanometers, at one of the peaks of absorption of A2E.

Such high-energy short-wave blue light hurts human eyes at two steps. First, since one of the absorption peaks is in the blue light spectrum, so that A2E absorbs such high-energy short-wave blue light release free radicals. Then such free radicals intensify the attack of the A2E on the retinal pigment epithelium, cause atrophy of the retinal pigment epithelium, and eventually kill the photosensitive cells. The photosensitive cells are those which turn light into electronic signals that are transmitted to the brain through the optical nerve of the humans. The electronic signals are converted to images by the brain. The death of the photosensitive cells causes deterioration of eyesight and even complete loss of eyesight.

The present invention is therefore intended to obviate or at least alleviate the problems encountered in prior art.

### SUMMARY OF INVENTION

It is an objective of the present invention to provide a method for adjusting a spectrum of blue light emitted from an OLED display.

To achieve the foregoing objective, the method includes the steps of providing a substrate and providing an anode, an OLED layer and a cathode on the substrate sequentially so that there is a resonant cavity between the anode and the cathode. A length of the resonant cavity is adjusted such that a portion of the spectrum components with wavelengths smaller than 435 nanometers has an energy under 50% of the spectrum.

By adjusting the length of the resonant cavity, the peak wavelength of the blue light is red-shifted. Based on this principle, the proportion of the components at predetermined wavelengths is adjusted to reduce the components of the blue light that are harmful to human eyes.

In another aspect, the energy is about 6.9% of the spectrum.

In another aspect, the energy is about 12.3% of the spectrum.

In another aspect, the energy is about 0% of the spectrum.

In another aspect, the OLED layer is a blue-light material which emits blue light with a peak wavelength larger than 450 nanometers in response to the adjustment of cavity length.

In another aspect, the peak wavelength is about 472 nanometers and the length of the resonant cavity is about 160 nanometers.

In another aspect, the peak wavelength is about 461 nanometers and the length of the resonant cavity is about 180 nanometers.

In another aspect, the peak wavelength is about 507 nanometers and the length of the resonant cavity is about 215nanometers.

In another aspect, the peak wavelength is about 480 nanometers and the length of the resonant cavity is about 300 nanometers.

In another aspect, the anode is made of reflective material and the cathode is made of trans-reflective material.

It is another objective of the present invention to provide an OLED display for adjusting a spectrum of harmful components from blue light.

To achieve the foregoing objective, the OLED display includes a substrate, an OLED layer, an anode formed on the substrate, and a cathode formed on the substrate so that there is a resonant cavity between the anode and the cathode. The resonant cavity has a cavity length of 160 to 300 nanometers such that a portion of the spectrum components with wavelengths smaller than 435 nanometers has an energy under 50% of the spectrum.

Other objectives, advantages and features of the present invention will be apparent from the following description referring to the attached drawings.

### BRIEF DESCRIPTION OF DRAWINGS

The present invention will be described via detailed illustration of four embodiments referring to the drawings wherein:
FIG. 1 is a side view of a typical OLED display;
FIG. 2 is a chart of the original spectrum of blue light versus a red-shifted spectrum of the blue light according to the first embodiment of the present invention;
FIG. 3 is a chart of the original spectrum of blue light versus a red-shifted spectrum of the blue light according to the second embodiment of the present invention;
FIG. 4 is a chart of the original spectrum of blue light versus a red-shifted spectrum of the blue light according to the third embodiment of the present invention; and
FIG. 5 is a chart of the original spectrum of blue light versus a red-shifted spectrum of the blue light according to the fourth embodiment of the present invention.

### DETAILED DESCRIPTION OF EMBODIMENTS

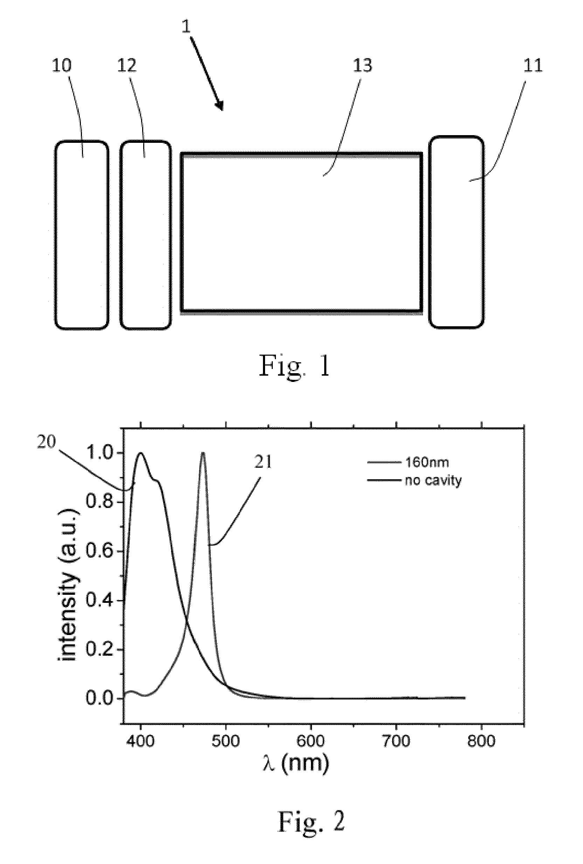

Referring to FIG. 1, there is an OLED display according to the present invention. The OLED display includes a substrate 10, a cathode 11 and an anode 12. Both of the cathode 11 and the anode 12 are formed on the substrate 10 so that a resonant cavity 13 is formed between the cathode 11 and the anode 12. The resonant cavity 13 includes a hole-injection layer, a hole-transporting layer, an emissive layer, and an electron-transporting layer. The anode 12 is made of reflective material while the cathode 11 is made of trans-reflective material so that light bounces back and forth in the resonant cavity 13 to provide optical feedback.

The method according to the present invention is to adjust the proportion of certain components of the emitted blue light through the display with predetermined wavelengths by adjusting the length of the resonant cavity 13.

Referring to FIG. 2, which shows a first embodiment of the present invention, wherein the curve 20 represents an organic material with original emitting peak wavelength at 400 nanometers. As shown by curve 20, the energy proportion of the components of the blue light with wavelengths smaller than 435 nanometers is about 72.6%. In the first embodiment, the length of the resonant cavity 13 is then adjusted and set to be 160 nanometers. Result shows the blue light passes the adjusted resonant cavity 13 with cavity length of 160 nanometers has the spectrum of the blue light which is red-shifted in compliance with the micro-cavity effects. Accordingly, the peak is red-shifted to 472 nanometers as indicated by a curve 21. Thus, the energy proportion of the components of the blue light with wavelengths smaller than 435 nanometers is reduced to 6.9%.

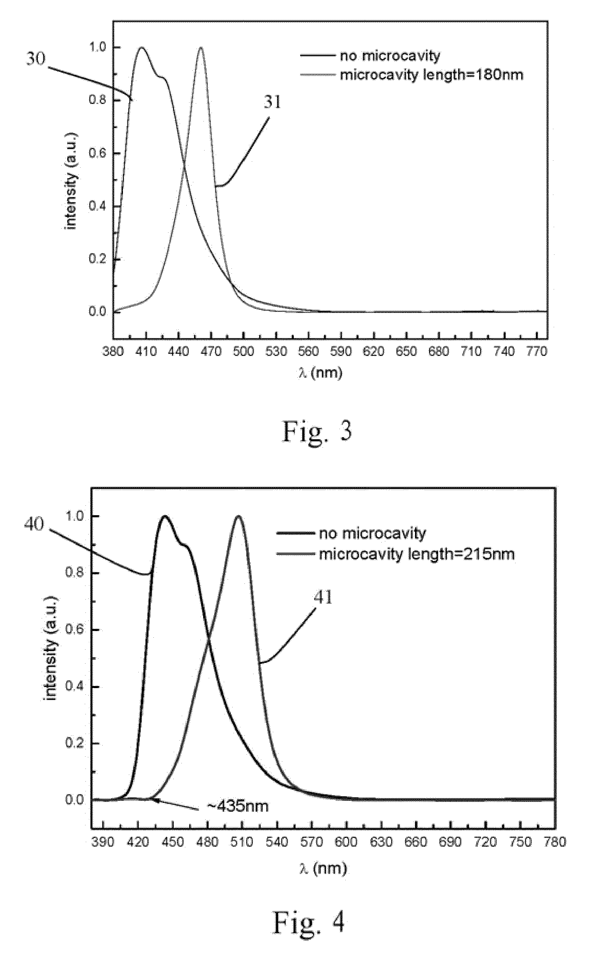

Referring to FIG. 3, which shows a second embodiment of the present invention, wherein the curve 30 represents an organic material with original emitting peak wavelength at 406 nanometers. As shown by curve 30, the en-ergy proportion of the components of the blue light with wavelengths smaller than 435 nanometers is about 66.7%. In the second embodiment, the length of the resonant cavity 13 is then adjusted and set to be 180 nanometers. Result shows the blue light passes the resonant cavity 13 with cavity length of 180 nanometers has the spectrum of the blue light which is red-shifted in compliance with the micro-cavity effects. Accordingly, the peak is red-shifted to 461 nanometers as indicated by a curve 31. Thus, the energy proportion of the components of the blue light with wavelengths smaller than 435 nanometers is reduced to 12.3%.

Referring to FIG. 4, which shows a third embodiment of the present invention, wherein the curve 40 represents an organic material with original emitting peak wavelength at 443 nanometers. As shown by curve 40, the energy proportion of the components of the blue light with wavelengths smaller than 435 nanometers is about 14.8%. In the third embodiment, the length of the resonant cavity 13 is then adjusted and set to be 215 nanometers. Result shows the blue light passes the resonant cavity 13 with cavity length of 215 nanometers has the spectrum of the blue light which is red-shifted in compliance with the micro-cavity effects. Accordingly, the peak is red-shifted to 507 nanometers as indicated by a curve 41. Thus, the energy proportion of the components of the blue light with wavelengths smaller than 435 nanometers is reduced to 0%.

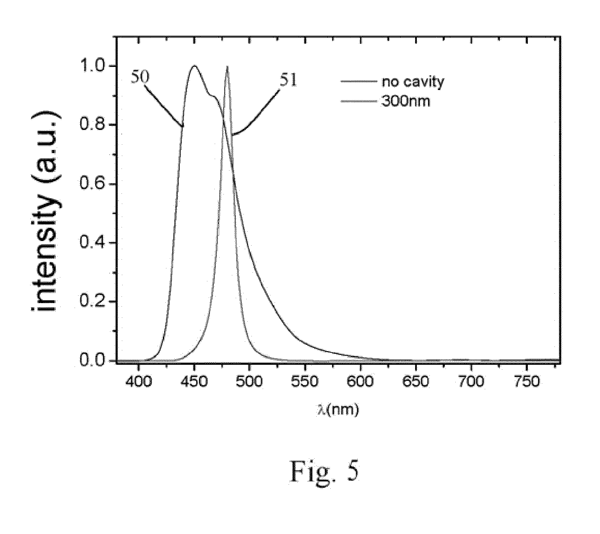

Referring to FIG. 5, which shows a fourth embodiment of the present invention, wherein the curve 50 represents an organic material with original emitting peak wavelength at 450 nanometers. As shown by curve 50, the energy proportion of the components of the blue light with wavelengths smaller than 435 nanometers is about 6.5%. In the fourth embodiment, the length of the resonant cavity 13 is then adjusted and set to be 300 nanometers. Result shows the blue light passes the resonant cavity 13 with cavity length of 300 nanometers has the spectrum of the blue light which is red-shifted in compliance with the micro-cavity effects. Accordingly, the peak is red-shifted to 480 nanometers as indicated by a curve 51. Thus, the energy proportion of the components of the blue light with wavelengths smaller than 435 nanometers is reduced to 0%.

The present invention has been described via the detailed illustration of the embodiments. Those skilled in the art can derive variations from the embodiments without departing from the scope of the present invention. Therefore, the embodiments shall not limit the scope of the present invention defined in the claims.

## Claims

1. A method for adjusting a spectrum of blue light emitted from an OLED display including the steps of:
providing a substrate;
providing an anode, an OLED layer and a cathode on the substrate so that a resonant cavity is formed between the anode and the cathode, the resonant cavity has a cavity length; and
adjusting the cavity length of the resonant cavity such that a portion of the spectrum components with wavelengths smaller than 435 nanometers has an energy under 50% of the spectrum.

2. The method according to claim 1, wherein the energy is about 6.9% of the spectrum.

3. The method according to claim 1, wherein the energy is about 12.3% of the spectrum.

4. The method according to claim 1, wherein the energy is about 0% of the spectrum.

5. The method according to claim 1, wherein the OLED layer is a blue-light material which emits blue light with a peak wavelength larger than 450 nanometers in response to the adjustment of cavity length.

6. An OLED display includes a substrate, an OLED layer, an anode formed on the substrate, and a cathode formed on the substrate so that there is a resonant cavity between the anode and the cathode, wherein the resonant cavity has a cavity length of 160 to 300 nanometers such that a portion of the spectrum components with wavelengths smaller than 435 nanometers has an energy under 50% of the spectrum.

7. The OLED display according to claim 6, wherein the energy is about 6.9% of the spectrum.

8. The OLED display according to claim 6, wherein the energy is about 12.3% of the spectrum.

9. The OLED display according to claim 6, wherein the energy is about 0% of the spectrum.

10. The OLED display according to claim 6, wherein the OLED layer is a blue-light material which emits blue light with a peak wavelength larger than 450 nanometers in response to the adjustment of cavity length.

11. The OLED display according to claim 7, wherein the peak wavelength is about 472 nanometers and the length of the resonant cavity is about 160 nanometers.

12. The OLED display according to claim 7, wherein the peak wavelength is about 461 nanometers and the length of the resonant cavity is about 180 nanometers.

13. The OLED display according to claim 7, wherein the peak wavelength is about 507 nanometers and the length of the resonant cavity is 215 nanometers.

14. The OLED display according to claim 7, wherein the peak wavelength is about 480 nanometers and the length of the resonant cavity is about 300 nanometers.

15. The OLED display according to claim 6, wherein the anode is made of reflective material and the cathode is made of trans-reflective material.
